# EUROPEAN PATENT APPLICATION

(11) **EP 2 645 012 A1**
(43) Date of publication of application: **02.10.2013**
(21) Application number: 11843323.4
(22) Date of filing: 21.07.2011
(51) Int. Cl.: F24J 2/38, F24J 2/54, H01L 31/052

(54) **ROBOT-TYPE SOLAR TRACKING APPARATUS**

(30) Priority: 26.11.2010 KR 20100118562; 07.03.2011 KR 20110019783
(71) Applicant: Raon Tech Co., Ltd., Guro-gu, Seoul 152-719 (KR)
(72) Inventor: PARK, Gi Ju, Gwangju-si Gyeonggi-do 464-842 (KR); JANG, Chul Soo, Hanam-si Gyeonggi-do 465-711 (KR); NAM, Hyung Do, Yongin-si Gyeonggi-do 446-955 (KR); SEO, Wan Yong, Goyang-si Gyeonggi-do 412-744 (KR)
(74) Representative: Colombo, Stefano Paolo
(86) International application number: PCT/KR2011/005368
(87) International publication number: WO 2012/070741

(57) **Abstract**

The present invention relates to a robotic sunlight tracking apparatus which can reduce power consumption and improve efficiency of solar photovoltaic power generation.

The robotic sunlight tracking apparatus includes a solar cell module for converting the sunlight incident thereon into electricity, a rotation shaft connected to a backside of the solar cell module for supporting the solar cell module 110 while rotating, a cylindrical body under the rotation shaft having a cam with a curvature formed as a recess in a surface of the cylindrical body in a preset depth and a motor built therein to rotate in one direction by operation of a timer, and fixing means for supporting and fixing the cylindrical body to ground, wherein the rotation shaft includes a cam follower at one side of the cylindrical body placed in the cam of the cylindrical body for moving following the cam as the motor rotates, and a lift arm connected to the cam follower for moving up/down to adjust an angle of the solar cell module when the cam follower moves following the cam.

## Description

### BACKGROUND OF THE DISCLOSURE

### Field of the Disclosure

The present invention relates to sunlight tracking apparatuses, and more particularly to a robotic sunlight tracking apparatus which can reduce power consumption and improve efficiency of solar photovoltaic power generation.

### Discussion of the Related Art

Currently, as fossil fuel, such as petroleum and coal, is being exhausted, development of substitutional energy is undergoing, and particularly development of technology for utilizing solar energy is undergoing, actively.

In power generation technology for producing electricity by utilizing the solar energy, there are solar thermal electric power generation in which a heat engine is driven by using solar heat to generate electricity, and the solar photovoltaic power generation in which a solar cell generates electricity by using sunlight.

In this instance, the solar cell used in the solar photovoltaic power generation includes a semiconductor compound device for converting the sunlight into the electricity, directly.

Most of the semiconductor compound devices include silicon Si and gallium arsenide GaAs. According to kinds of the semiconductor compounds used in the solar cell, various solar cells, such as dye-sensitized solar cells, CIGS solar cells, CdTe solar cells, and so on are developed and used, currently.

In general, a group of the cells put together in parallel and/or series is called as a module, and a structure is used for fixedly securing the modules for the solar photovoltaic power generation. In the structure, there are fixed type, single axis type, and two axes type, wherein the two axes type which generates the power while tracking the sun has the best efficiency. However, since a motor is required for tracking the sun, the two axes type is not used widely due to a drawback of requirement for separate power source.

And, though a tracking type solar photovoltaic power generation system uses a sensor for sensing a light, the system has drawbacks in that, since a sensing range of the sensor is limited, the system can not track the sun when the sum is positioned outside of the sensing range if the sun is shaded by cloud for a long time, requires a high cost, and is dependent on sensitivity of the sensor, very much.

### SUMMARY OF THE DISCLOSURE

Accordingly, the present invention is directed to a robotic sunlight tracking apparatus.

An object of the present invention is to provide a robotic sunlight tracking apparatus in which a cam type structure is employed for rotating a solar cell module with one motor to move an azimuth angle and an altitude angle of a tracker at a time with small power consumption to improve power generation efficiency.

Another object of the present invention is to provide a robotic sunlight tracking apparatus in which a cylindrical cam structure is employed enabling two axes control with single motor for tracking an azimuth angle and an altitude angle of sunlight at a time to improve power generation efficiency.

Additional advantages, objects, and features of the disclosure will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a robotic sunlight tracking apparatus includes a solar cell module for converting the sunlight incident thereon into electricity, a rotation shaft connected to a backside of the solar cell module for supporting the solar cell module 110 while rotating, a cylindrical body under the rotation shaft having a cam with a curvature formed as a recess in a surface of the cylindrical body in a preset depth and a motor built therein to rotate in one direction by operation of a timer, and fixing means for supporting and fixing the cylindrical body to ground, wherein the rotation shaft includes a cam follower at one side of the cylindrical body placed in the cam of the cylindrical body for moving following the cam as the motor rotates, and a lift arm connected to the cam follower for moving up/down to adjust an angle of the solar cell module when the cam follower moves following the cam.

In another aspect of the present invention, a robotic sunlight tracking apparatus includes a solar cell module for converting the sunlight incident thereon into electricity, a rotation shaft connected to a backside of the solar cell module for supporting the solar cell module while rotating, a cylindrical body under the rotation shaft having a main cam with a curvature formed as a recess in a surface of the cylindrical body in a preset depth and a motor built therein to rotate in one direction by operation of a timer, a supplementary cam with a curvature formed as a recess in a surface of the cylindrical body in a preset depth to have a portion spaced from the main cam and one side and the other side connected to the main cam, and fixing means for supporting and fixing the cylindrical body to ground, wherein the rotation shaft includes a cam follower at one side of the cylindrical body placed in the main cam or the supplementary cam of the cylindrical body for moving following the curve of the cam as the motor rotates, and a lift arm connected to the cam follower for moving up/down to adjust an angle of the solar cell module when the cam follower moves following the main cam or the supplementary cam.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:

FIG. 1 illustrates a front side perspective view of a robotic sunlight tracking apparatus in accordance with a first preferred embodiment of the present invention.

FIG. 2 illustrates a back side perspective view of a robotic sunlight tracking apparatus in accordance with a first preferred embodiment of the present invention.

FIG. 3 illustrates a side view of the rotation shaft in FIG. 1.

FIG. 4 illustrates a perspective view of the first rotation shaft and the first hinge coupling unit in FIG. 3 in detail.

FIG. 5 illustrates a side view of the second rotation shaft and the second hinge coupling unit in FIG. 3, in detail.

FIG. 6 illustrates a graph showing a relation between an altitude angle and an azimuth angle measured with a robotic sunlight tracking apparatus of the present invention.

FIGS. 7 - 9 illustrate diagrams showing rotation angles of a rotation shaft according to the graph in FIG. 6.

FIG. 10 illustrates a side view of a robotic sunlight tracking apparatus in accordance with a second preferred embodiment of the present invention.

FIG. 11 illustrates a back side perspective view of a robotic sunlight tracking apparatus in accordance with a second preferred embodiment of the present invention.

FIG. 12 illustrates a side view of the rotation shafts in FIG. 10.

FIG. 13 illustrates a perspective view of the first rotation shaft and the first hinge coupling unit in FIG. 12 in detail.

FIG. 14 illustrates a side view of the second rotation shaft and the second hinge coupling unit in FIG. 12, in detail.

### DESCRIPTION OF SPECIFIC EMBODIMENTS

Reference will now be made in detail to the specific embodiments of the present invention, examples of which are illustrated in the accompanying drawings. Wherever possible, the same reference numbers will be used throughout the drawings to refer to the same or like parts.

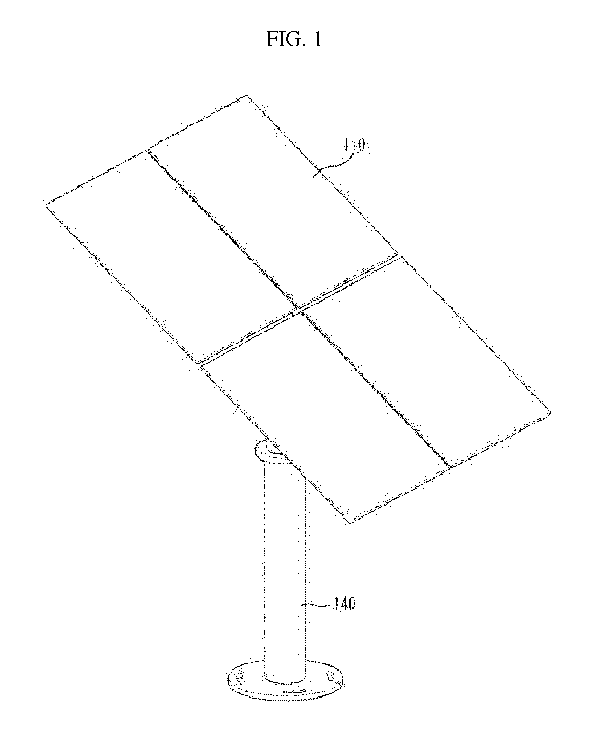

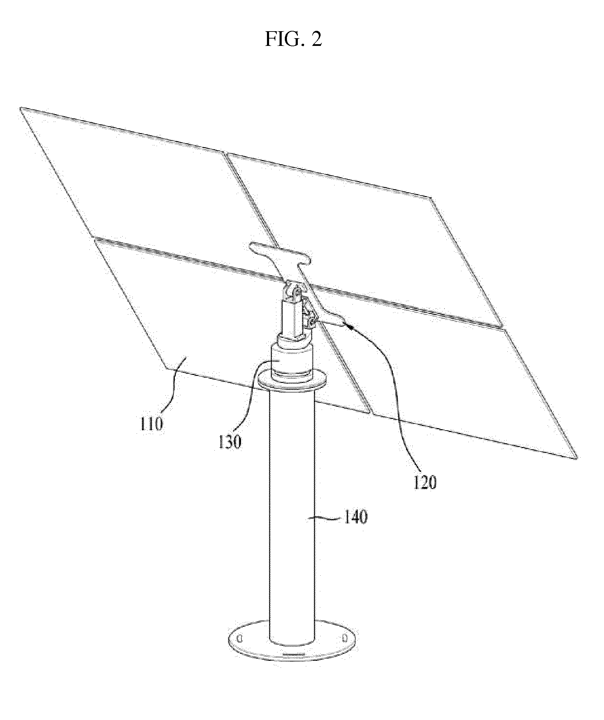

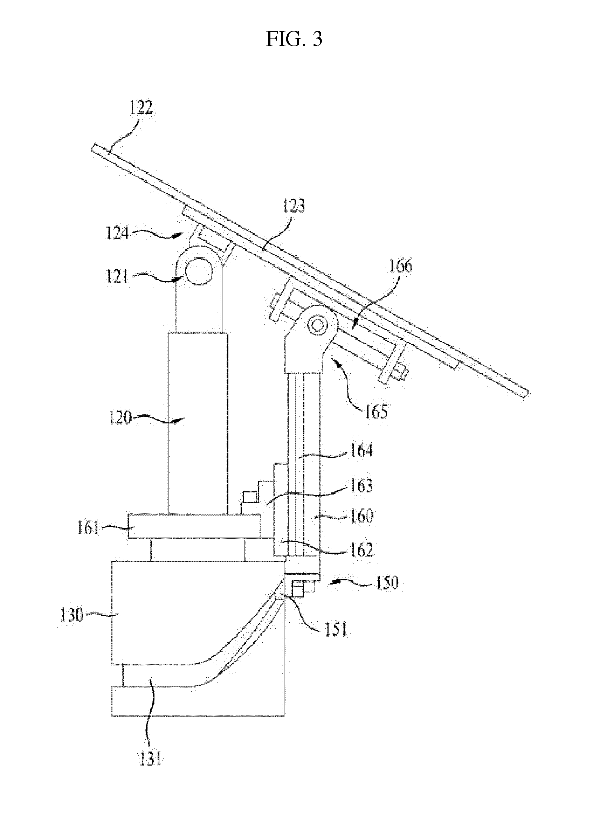

FIG. 1 illustrates a front side perspective view of a robotic sunlight tracking apparatus in accordance with a first preferred embodiment of the present invention, FIG. 2 illustrates a back side perspective view of a robotic sunlight tracking apparatus in accordance with a first preferred embodiment of the present invention, and FIG. 3 illustrates a side view of the rotation shafts in FIG. 1.

Referring to FIGS. 1 - 3, the robotic sunlight tracking apparatus includes a solar cell module 110 for converting the sunlight incident thereon into electricity, a rotation shaft 120 connected to a backside of the solar cell module 110 for supporting the solar cell module 110 while rotating, a cylindrical body 130 under the rotation shaft 120 having a cam 131 with a curvature formed as a recess in a surface of the cylindrical body 130 in a preset depth and a motor (Not shown) built therein to rotate in one direction by operation of a timer, and a fixing means 140 for supporting and fixing the cylindrical body 130 to ground, wherein the rotation shaft 120 includes a cam follower 150 at one side of the cylindrical body 130 placed in the cam 131 of the cylindrical body 130 for moving following the cam 131 as the motor rotates, and a lift arm 160 connected to the cam follower 150 for moving up/down to adjust an angle of the solar cell module 110 when the cam follower 150 moves following the cam 131.

In this instance, the rotation shaft 120 supports the solar cell module 110 and has a first rotation shaft 121 for making an angle of the solar cell module 110 to change following the up/down movement of the lift arm 160.

The cell portion of the solar cell module 110 which collects the sunlight has a high heat generation rate of heat reaching to hundreds of degrees of temperature due to the collected light. Since the heat makes the efficiency of the solar cell module 110 poor, a heat dissipation plate (Not shown) is mounted to a backside of the solar cell module 110 for dissipating the heat from the cell portion.

Four solar cell modules 110 construe one array, and the rotation shaft 120 includes an "H" shaped securing plate 122 fastened to the backsides of the four solar cell modules 110 for supporting the solar cell modules 110, a reinforcing plate 123 attached to a backside of the securing plate 122 for reinforcing the securing plate 122, and a first hinge coupling unit 124 for connecting the reinforcing plate 123 to the first rotation shaft 121.

In order to support the lift arm 160, formed at one side of the lift arm 160, there are a lift arm supporting portion 161 for supporting the lift arm 160 when the lift arm 160 moves up/down round the first rotation shaft 121, a fixed end 162 at one side of the lift arm 160 to slide when the lift arm 160 moves up/down, a fixing bracket 163 for fixing the fixed end 162 to the lift arm supporting portion 161, and a movable rail 164 formed in conformity with the fixed end 162 for making the lift arm 160 to move up/down following the fixed end 162.

The lift arm 160 has one side connected to the cam follower 150, and the other side connected to the reinforcing plate 123 on the backside of the solar cell module 110.

Between the connection of the other side of the lift arm 160 to the reinforcing plate 123, there is a second rotation shaft 165 mounted rotatable with the up/down movement of the lift arm 160 to construe a second hinge coupling unit 166.

There is a roller 151 at an end of the cam follower 150 placed in the cam 131 of the cylindrical body 130 for moving following the cam 131.

Therefore, when the roller 151 moves following the curve of the cam 131, the movable rail 164 at one side of the lift arm 160 moves up/down following the fixed end 162 by a rolling motion of the roller 151.

In this instance, the one motor in the cylindrical body 130 is programmed with a timer to rotate once the curve of the cam 131 in 24 hours following an azimuth angle and an altitude angle of the sun measured for 24 hours starting from sun rise to sun set.

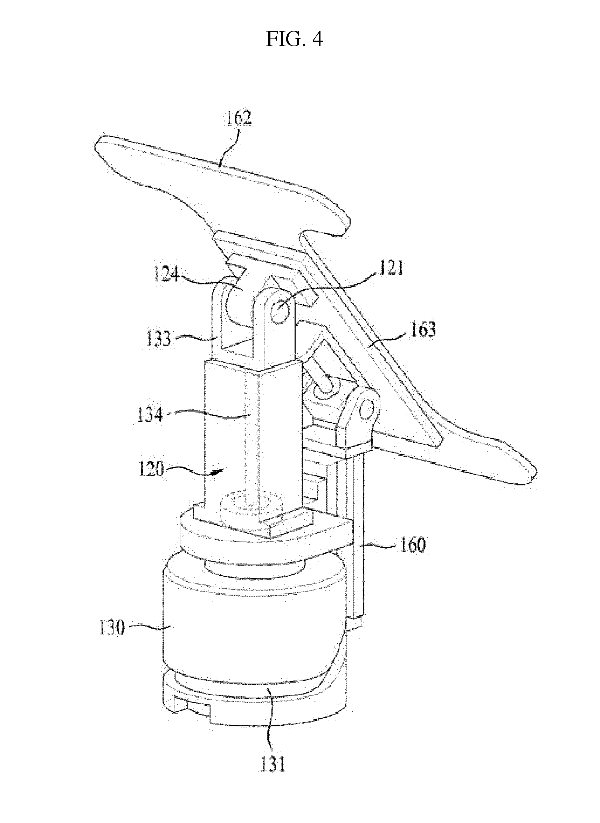

FIG. 4 illustrates a perspective view of the first rotation shaft and the first hinge coupling unit in FIG. 3 in detail.

Referring to FIG. 4, over the cylindrical body 130, there is the first rotation shaft 121 fixed to the reinforcing plate 163 through the rotation shaft 120. In this instance, the first rotation shaft 121 is placed in a fixing portion 133 coupled to a top of the rotation shaft 120 so that the securing plate 122 rotates in one direction smoothly when the lift arm 160 moves up/down.

In the meantime, there is a hollow shaft 134 in the rotation shaft 120 extended through the cylindrical body 130 and the fixing portion 133 for enabling pass of a cable for transmitting electricity from the solar cell module 110.

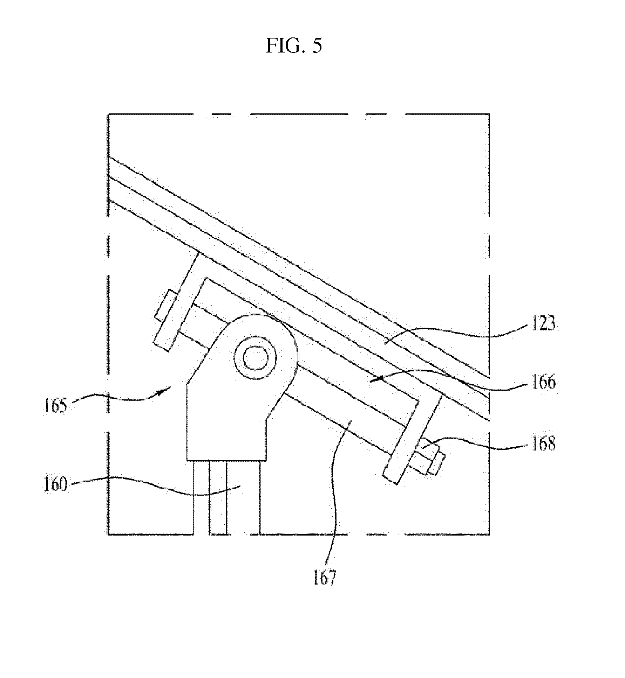

FIG. 5 illustrates a side view of the second rotation shaft and the second hinge coupling unit in FIG. 3, in detail.

Referring to FIG. 5, the second rotation shaft 165 is on the other side of the lift arm 160 and has a slide bar 167 placed therein for rotating the slide bar 167 of the second hinge coupling unit 166 in left/right directions following the up/down movement of the lift arm 160.

The slide bar 167 has supporting means 168 at both ends of the slide bar 167 for fastening to the reinforcing plate 123 in a state the lift arm 160 is placed between the second rotation shaft 165 for the lift arm 160 to move in left/right directions.

In the meantime, though the embodiment suggests the second rotation shaft 165 and the second hinge coupling unit 166, but the embodiment is not limited to this. In a state the lift arm 160 is connected to the backside of the solar cell module 110 directly, the solar cell module 110 can also be rotated appropriately according to the azimuth angle and the altitude angle of the sun.

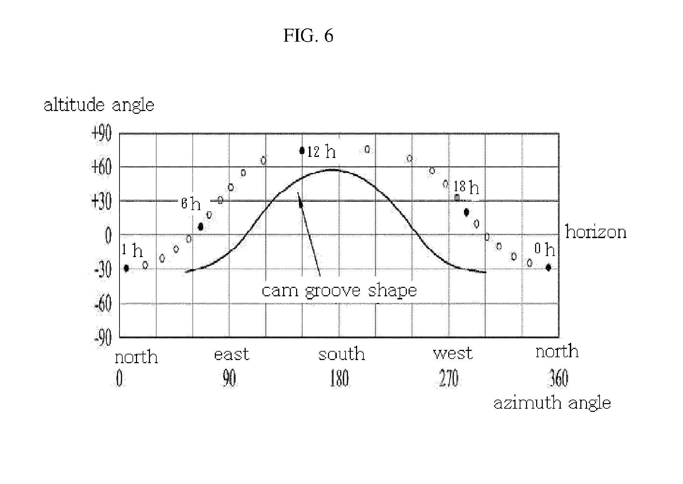

FIG. 6 illustrates a graph showing a relation between an altitude angle and an azimuth angle measured with a robotic sunlight tracking apparatus of the present invention.

Referring to FIG. 6, it can be known that the altitude angle of the sun varies with time.

Therefore, by tracking the movement of the sun and measuring the azimuth angle and the altitude angle of the sun starting from sun rise to sun set at every hour, and plotting a result of measurement as a graph, averages thereof are calculated, to obtain a cam curve.

By tracking the movement of the sun starting from sun rise to sun set, plotting variations of the azimuth angle and the altitude angle of the sun as the graph, averages thereof are calculated, the cam 131 curve is formed in a surface of the cylindrical body 130, and the altitude angle and the azimuth angle are programmed mechanically such that the solar cell module 110 rotates following the cam 131 curve which describes positional variation of the sun as it is, for the robotic sunlight tracking apparatus to track the sun.

Since, by making the roller 151 of the cam follower 150 to move following the cam 131 curve formed in the surface of the cylindrical body 130 according to the variations of the azimuth angle and the altitude angle of the sun, the azimuth angle of the sun is tracked, and the altitude angle of the sun is tracked with the lift arm 160, power production with the solar cell module 110 can be maximized.

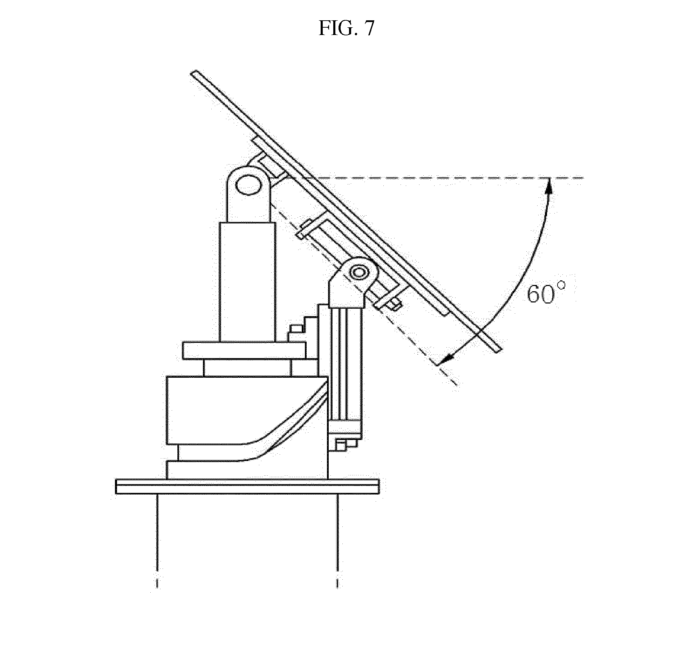

FIGS. 7 - 9 illustrate diagrams showing rotation angles of a rotation shaft according to the graph in FIG. 6.

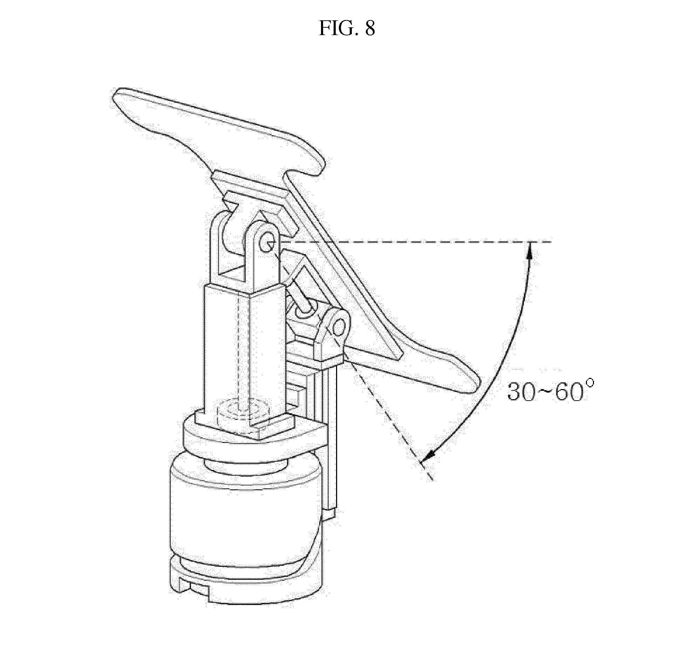

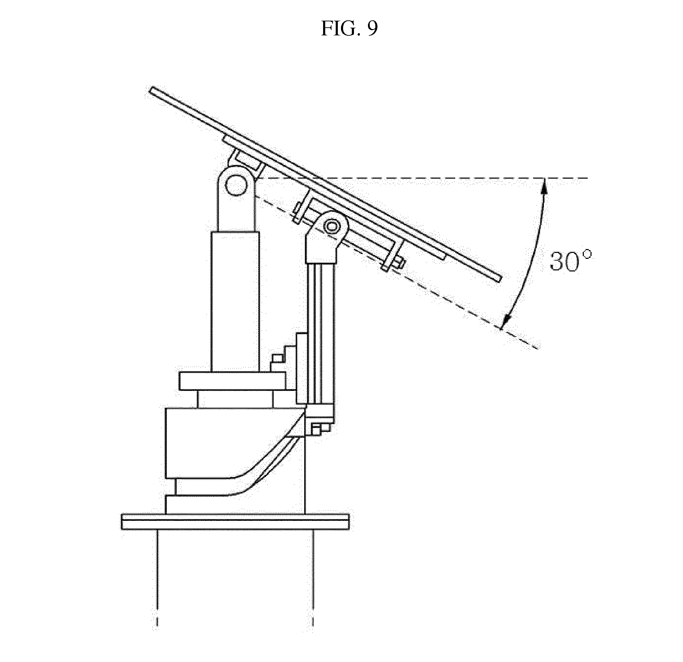

FIG. 7 illustrates the rotation shaft 120 maintained at about 60° at 8 - 10 o'clock in the morning, and at 3 - 5 o'clock in the afternoon to have the sunlight incident on the solar cell module 110, FIG. 8 illustrates the rotation shaft 120 maintained at about 30 - 60° at 10 - 11 o'clock in the morning, and at 2 - 3 o'clock in the afternoon to have the sunlight incident on the solar cell module 110, and FIG. 9 illustrates the rotation shaft 120 maintained at about 30° starting from 11 o'clock in the morning to 2 o'clock in the afternoon to have the sunlight incident on the solar cell module 110.

That is, as the roller 151 of the cam follower 150 rotates following the cam 131 curve for 24 hours, the robotic sunlight tracking apparatus enables to have the sunlight incident thereon while maintaining an angle of 30° in the morning and the afternoon, and 60° in the daytime, permitting to have the sunlight incident thereon to the maximum.

According to this, as the rotation shaft 120 maintains an optimum angle to the sun proper to each time band owing to the up/down movement of the lift arm 160 connected to the cam follower 150 which follows the rotation of the cam follower 150 that follows the cam curve 131, light collecting efficacy of the solar cell module 110 can be improved, further.

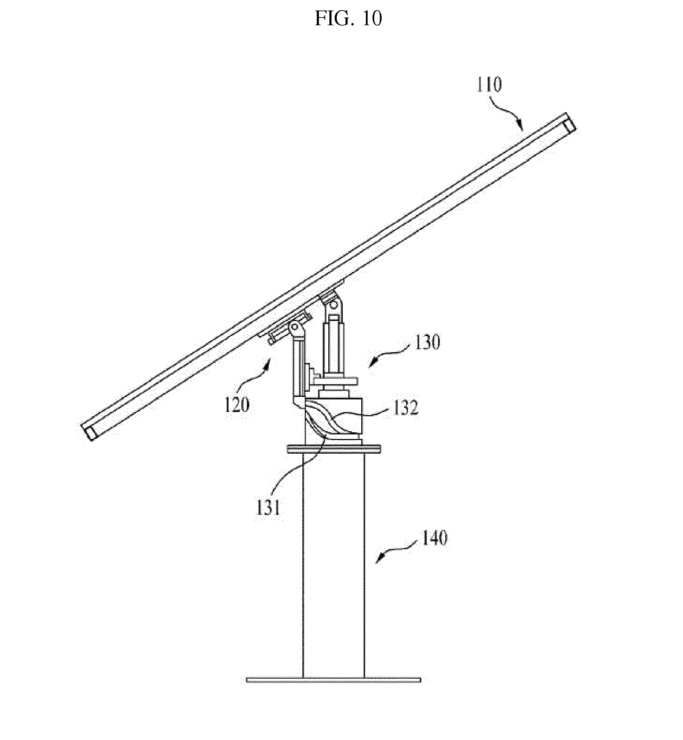

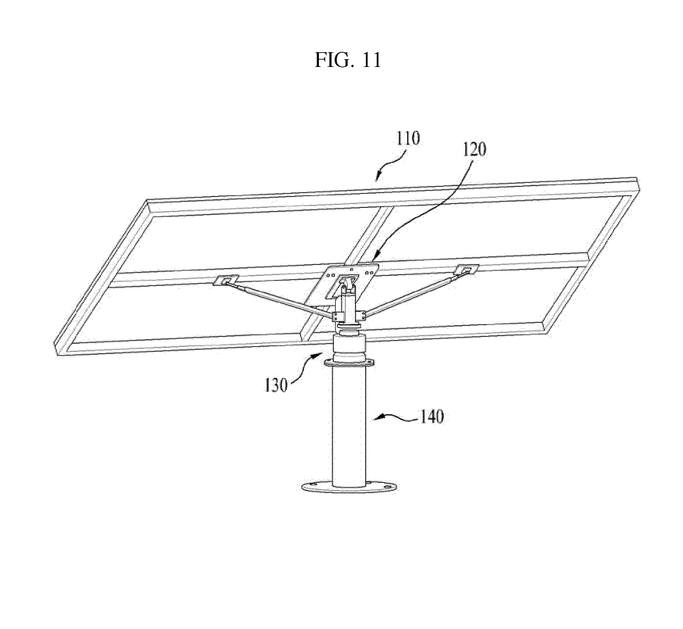

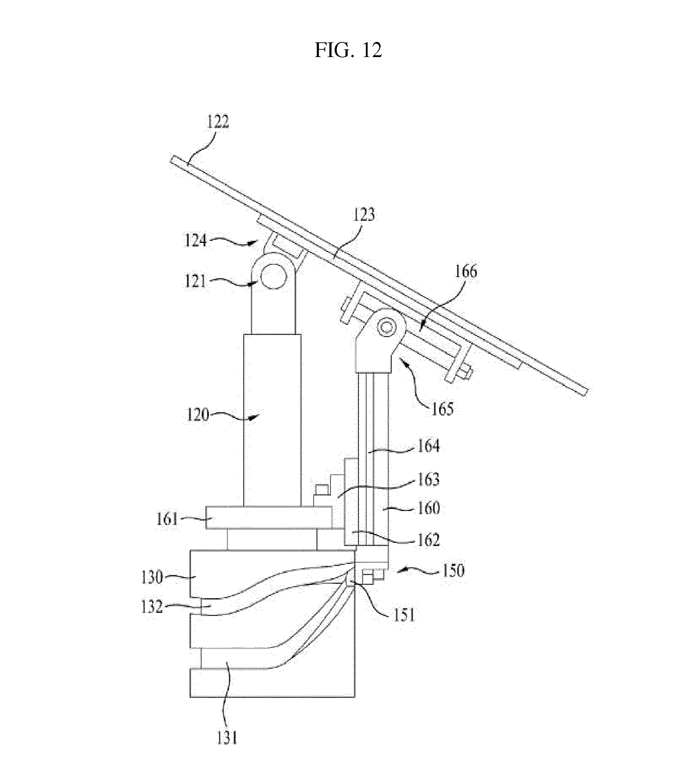

FIG. 10 illustrates a front side perspective view of a robotic sunlight tracking apparatus in accordance with a second preferred embodiment of the present invention, FIG. 11 illustrates a back side perspective view of a robotic sunlight tracking apparatus in accordance with a second preferred embodiment of the present invention, and FIG. 12 illustrates a side view of the rotation shafts in FIG. 10.

Referring to FIGS. 10 - 12, the robotic sunlight tracking apparatus includes a solar cell module 110 for converting the sunlight incident thereon into electricity, a rotation shaft 120 connected to a backside of the solar cell module 110 for supporting the solar cell module 110 while rotating, a cylindrical body 130 under the rotation shaft 120 having a main cam 131 with a curvature formed as a recess in a surface of the cylindrical body 130 in a preset depth and a motor (Not shown) built therein to rotate in one direction by operation of a timer, a supplementary cam 132 with a curvature formed as a recess in a surface of the cylindrical body 130 in a preset depth to have a portion spaced from the main cam 131 and to be connected to one side of the main cam 131, and fixing means 140 for supporting and fixing the cylindrical body 130 to ground, wherein the rotation shaft 120 includes a cam follower 150 at one side of the cylindrical body 130 placed in the main cam 131 or the supplementary cam 132 of the cylindrical body 130 for moving following the main cam 131 or the supplementary cam 132 as the motor rotates, and a lift arm 160 connected to the cam follower 150 for moving up/down to adjust an angle of the solar cell module 110 when the cam follower 150 moves following the main cam 131 or the supplementary cam 132.

In this instance, the rotation shaft 120 supports the solar cell module 110 and has a first rotation shaft 121 for making an angle of the solar cell module 110 to change following the up/down movement of the lift arm 160.

Though two of the main cam 131 and the supplementary cam 132 are formed in the cylindrical body 130 for appropriate dealing with a case when there is seasonal or regional deviation of the altitude angle and the azimuth angle, more than two cams can be formed.

Four solar cell modules 110 construe one array, and the rotation shaft 120 includes a securing plate 122 fastened to the backsides of the four solar cell modules 110 for supporting the solar cell modules 110, a reinforcing plate 123 attached to a backside of the securing plate 122 for reinforcing the securing plate 122, and a first hinge coupling unit 124 for connecting the reinforcing plate 123 to the first rotation shaft 121.

In order to support the lift arm 160, formed at one side of the lift arm 160, there are a lift arm supporting portion 161 for supporting the lift arm 160 when the lift arm 160 moves up/down round the first rotation shaft 121, a fixed end 162 at one side of the lift arm 160 to slide when the lift arm 160 moves up/down, a fixing bracket 163 for fixing the fixed end 162 to the lift arm supporting portion 161, and a movable rail 164 formed in conformity with the fixed end 162 for making the lift arm 160 to move up/down following the fixed end 162.

The lift arm 160 has one side connected to the cam follower 150, and the other side connected to the reinforcing plate 123 on the backside of the solar cell module 110.

Between the connection of the other side of the lift arm 160 to the reinforcing plate 123, there is a second rotation shaft 165 mounted rotatable with the up/down movement of the lift arm 160 to construe a second hinge coupling unit 166.

There is a roller 151 at an end of the cam follower 150 placed in the main cam 131 or the supplementary cam 132 of the cylindrical body 130 for moving following the main cam 131 or the supplementary cam 132.

Therefore, when the roller 151 moves following the curve of the main cam 131 or the supplementary cam 132, the movable rail 164 at one side of the lift arm 160 moves up/down following the fixed end 162 by a rolling motion of the roller 151.

In this instance, the one motor in the cylindrical body 130 is programmed with a timer to rotate once the curve of the main cam 131 or the supplementary cam 132 in 24 hours following an azimuth angle and an altitude angle of the sun measured for 24 hours starting from sun rise to sun set.

In the meantime, the main cam 131 and the supplementary cam 132 are formed by mechanical programming utilizing average azimuth angles and altitude angles of the sun accumulated for 30 years provided by the meteorological observatory. Therefore, by tracking the sunlight with a fixed program according to the altitude angle and the azimuth angle of the sun, malfunction can be minimized.

That is, though, in general, the sunlight is tracked with an additional sensor, such as a pyranometer sensor, when malfunction takes place due to difficulty in measurement caused by shadow and the like, the present invention can minimize malfunction by repetitive tracking of the altitude angle and the azimuth angle of the sun by utilizing the mechanical programming.

Moreover, since power is supplied from an outside for driving the motor with power consumption as low as 8W enabling to reduce the power consumption, and an emergency battery (Not shown) can be provided for operation of the motor when the outside power fails. In this instance, the emergency battery is re-chargeable for supplying power to the motor when the outside power fails.

The robotic sunlight tracking apparatus in accordance with the second preferred embodiment of the present invention is programmed to track a position of the sun matched to the present altitude and azimuth angles of the sun automatically when the robotic sunlight tracking apparatus is come into operation again after black out.

That is, when the robotic sunlight tracking apparatus is put into operation again after failure of the robotic sunlight tracking apparatus is repaired, the robotic sunlight tracking apparatus can track the position of the sun matched to the present altitude and azimuth angles of the sun automatically by making the robotic sunlight tracking apparatus to be operative with reference to the GPS.

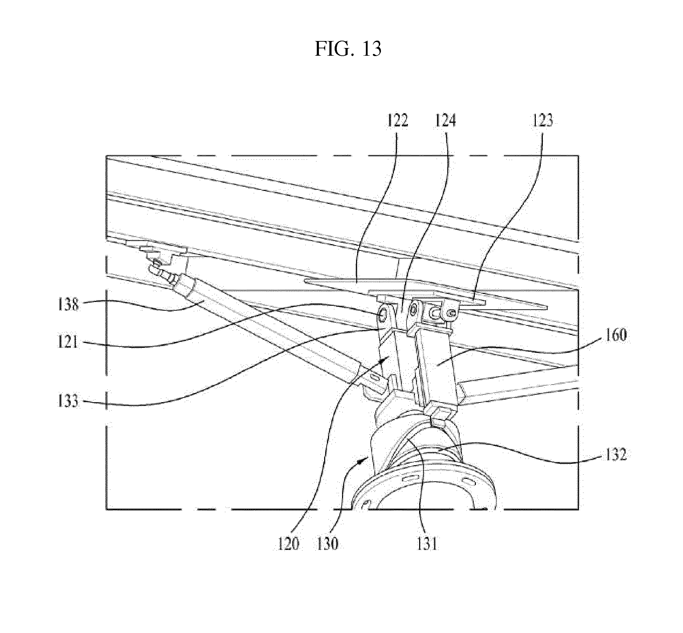

FIG. 13 illustrates a perspective view of the first rotation shaft and the first hinge coupling unit in FIG. 12 in detail.

Referring to FIG. 13, over the cylindrical body 130, there is the first rotation shaft 121 fixed to the reinforcing plate 163 through the rotation shaft 120. In this instance, the first rotation shaft 121 is placed in a fixing portion 133 coupled to a top of the rotation shaft 120 so that the securing plate 122 rotates in one direction smoothly when the lift arm 160 moves up/down.

In the meantime, there is a hollow shaft 134 in the rotation shaft 120 extended through the cylindrical body 130 and the fixing portion 133 for enabling pass of a cable for transmitting electricity from the solar cell module 110.

There are extensible supporting members 138 on both sides of an upper side of the cylindrical body 130 extended to the backside of the solar cell module 110, respectively. Each of the supporting members 138 varies a length thereof when the cam follower 150 moves following the main cam 131 or the supplementary cam 132 of the cylindrical body 130.

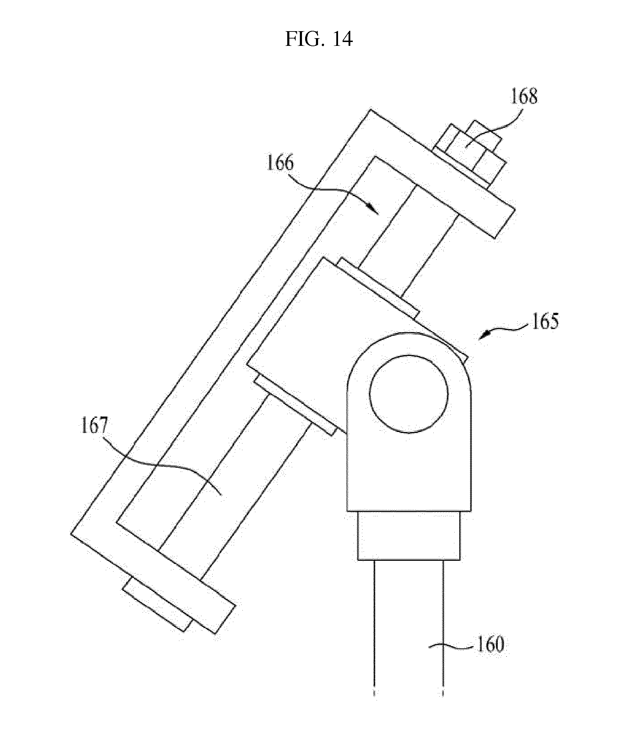

FIG. 14 illustrates a side view of the second rotation shaft and the second hinge coupling unit in FIG. 12, in detail.

Referring to FIG. 14, the second rotation shaft 165 is on the other side of the lift arm 160 and has a slide bar 167 placed therein for rotating the slide bar 167 of the second hinge coupling unit 166 in left/right directions following the up/down movement of the lift arm 160.

The slide bar 167 has supporting means 168 at both ends of the slide bar 167 for fastening to the reinforcing plate 123 in a state the lift arm 160 is placed between the second rotation shaft 165 for the lift arm 160 to move in left/right directions.

In the meantime, though the embodiment suggests the second rotation shaft 165 and the second hinge coupling unit 166, but the embodiment is not limited to this. In a state the lift arm 160 is connected to the backside of the solar cell module 110 directly, the solar cell module 110 can be rotated appropriately according to the azimuth angle and the altitude angle of the sun.

By tracking the movement of the sun starting from sun rise to sun set, plotting variations of the azimuth angle and the altitude angle of the sun as the graph, averages thereof are calculated, the main cam 131 or the supplementary cam 132 curve is formed in a surface of the cylindrical body 130, and the altitude angle and the azimuth angle are programmed mechanically such that the solar cell module 110 rotates following the cam 131 curve which describes positional variation of the sun as it is, for the robotic sunlight tracking apparatus to track the sun.

Since, by making the roller 151 of the cam follower 150 to move following the main cam 131 or the supplementary cam 132 curve formed in the surface of the cylindrical body 130 according to the variations of the azimuth angle and the altitude angle of the sun, the azimuth angle of the sun is tracked, and the altitude angle of the sun is tracked with the lift arm 160, power production with the solar cell module 110 can be maximized.

As has been described, the robotic sunlight tracking apparatus of the present invention has the following advantages.

First, as the solar cell module has the sunlight incident thereon at 60° in the morning and in the evening, and 30° in the daytime while the solar cell module is rotating at a fixed speed following the fixed speed rotation of the motor and moving up/down according to the up/down movement of the lift arm following the cam curve, the robotic sunlight tracking apparatus of the present invention can improve power generation efficiency.

Second, the mechanical programming of the variation of the altitude and azimuth angles of the sun with the cam curve permits tracking of the position of the sun without other control functions, thereby providing maximum power generation efficiency.

Third, the two axes rotation made available only with one motor permits to track the sunlight only with power in a range of 15W.

Fourth, the 360° rotation following the cam curve for 24 hours permits easy control and no directional control of the motor permits to reduce power consumption.

Fifth, the minimized control units and driving units required for tracking the sun permits installation and maintenance easier than other products.

Sixth, by providing a mode in which the tracking of the sun is not made in strong wind, snow, rain, a cloudy day, there is no power consumption of the motor.

Seventh, the mechanical programming inputted to the cylindrical cam by utilizing average azimuth angles and altitude angles of the sun accumulated for 30 years provided by the meteorological observatory permits the tracking of the sunlight by two axes control by using single motor.

Eighth, the cylindrical cam with at least two stages permits to track the sunlight matched to the altitude angle and the azimuth angle of the sun according to a season and a region.

Ninth, the synchronized sunlight tracking system permits tracking of the sunlight matched to the present altitude angle and the azimuth angle of the sun in black out or bad weather.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. A robotic sunlight tracking apparatus comprising:
a solar cell module for converting the sunlight incident thereon into electricity;
a rotation shaft connected to a backside of the solar cell module for supporting the solar cell module while rotating;
a cylindrical body under the rotation shaft having a cam with a curvature formed as a recess in a surface of the cylindrical body in a preset depth and a motor built therein to rotate in one direction by operation of a timer; and
fixing means for supporting and fixing the cylindrical body to ground,
wherein the rotation shaft includes;
a cam follower at one side of the cylindrical body placed in the cam of the cylindrical body for moving following the cam as the motor rotates, and
a lift arm connected to the cam follower for moving up/down to adjust an angle of the solar cell module when the cam follower moves following the cam.

2. The apparatus as claimed in claim 1, wherein the rotation shaft includes a first rotation shaft for changing an angle of the solar cell module according to up/down movement of the lift arm and supports the solar cell module.

3. The apparatus as claimed in claim 2, wherein the rotation shaft further includes;
a lift arm supporting portion for supporting the lift arm when the lift arm moves up/down round the first rotation shaft formed at one side of the lift arm for supporting the lift arm,
a fixed end at one side of the lift arm to slide when the lift arm moves up/down,
a fixing bracket for fixing the fixed end to the lift arm supporting portion, and
a movable rail formed in conformity with the fixed end for making the lift arm to move up/down following the fixed end.

4. The apparatus as claimed in claim 1, wherein the rotation shaft further includes;
a securing plate fastened to the backsides of a plurality of solar cell modules for supporting the solar cell modules,
a reinforcing plate attached to a backside of the securing plate for reinforcing the securing plate, and
a first hinge coupling unit for connecting the reinforcing plate to the first rotation shaft.

5. The apparatus as claimed in claim 4, wherein the lift arm has one side connected to the cam follower, and the other side connected to the reinforcing plate on the backside of the solar cell module, and between the connection of the other side of the lift arm to the reinforcing plate, there is a second rotation shaft mounted rotatable with the up/down movement of the lift arm to construe a second hinge coupling unit.

6. The apparatus as claimed in claim 1, wherein the cam follower includes a roller mounted to an end thereof placed in the cam of the cylindrical body for moving following the cam.

7. A robotic sunlight tracking apparatus comprising:
a solar cell module for converting the sunlight incident thereon into electricity;
a rotation shaft connected to a backside of the solar cell module for supporting the solar cell module while rotating;
a cylindrical body under the rotation shaft having a main cam with a curvature formed as a recess in a surface of the cylindrical body in a preset depth and a motor built therein to rotate in one direction by operation of a timer;
a supplementary cam with a curvature formed as a recess in a surface of the cylindrical body in a preset depth to have a portion spaced from the main cam and one side and the other side connected to the main cam; and
fixing means for supporting and fixing the cylindrical body to ground,
wherein the rotation shaft includes;
a cam follower at one side of the cylindrical body placed in the main cam or the supplementary cam of the cylindrical body for moving following the curve of the cam as the motor rotates, and
a lift arm connected to the cam follower for moving up/down to adjust an angle of the solar cell module when the cam follower moves following the main cam or the supplementary cam.

8. The apparatus as claimed in claim 7, wherein the motor is driven by an external power source or an emergency battery.

9. The apparatus as claimed in claim 7, wherein the motor tracks a position of the sunlight matched to the present altitude and azimuth angles of the sun owing to the timer operative with reference to the GPS.

10. The apparatus as claimed in claim 7, wherein the cam follower includes a roller mounted to an end thereof placed in the cam of the cylindrical body for moving following the main cam or the supplementary cam.
